# FASCICULE DE BREVET EUROPEEN

(11) **EP 4 658 008 B1**
(45) Date de publication et mention de la délivrance du brevet: **12.08.2026**
(21) Numéro de dépôt: 25179497.0
(22) Date de dépôt: 28.05.2025
(51) Int. Cl.: H05K 7/20, H05K 1/02, H10W 40/10, H10W 40/22, H10W 40/43, H10W 42/20, H10W 70/68, H10W 90/00

(54) **ENSEMBLE DE DISSIPATION THERMIQUE**
WÄRMEABLEITUNGSANORDNUNG
HEAT DISSIPATING ASSEMBLY

(30) Priorité: 30.05.2024 FR 2405631
(43) Date de publication de la demande: 03.12.2025
(73) Titulaire: SAGEMCOM BROADBAND SAS, 92270 Bois-Colombes (FR)
(72) Inventeur: JEANROT, Nathan, 92270 Bois-Colombes (FR); BEAUTE, Laurent, 92270 Bois-Colombes (FR)
(74) Mandataire: Novagraaf Technologies

(56) Documents cités:
- US-A1- 2010 157 544
- US-A1- 2022 377 945
- US-A1- 2022 386 448
- US-A1- 2023 413 481

## Description

### Domaine technique

La présente invention concerne de manière générale un ensemble de dissipation thermique, un dispositif électronique contenant au moins un tel ensemble de dissipation thermique et un procédé de fabrication permettant de fabriquer un tel ensemble de dissipation thermique et un tel dispositif électronique.

### État de la technique

Il est connu dans l'art antérieur des dissipateurs thermiques, comme, par exemple, divulgué dans US 2010/157544 A1. En contrepartie, ces systèmes peuvent présenter des inconvénients liés à un poids élevé, un cout élevé et/ou des performances thermiques limitées. Résumé de l'invention

Un but de la présente description est de répondre aux inconvénients de l'art antérieur mentionnés ci-dessus et en particulier, tout d'abord, de proposer un ensemble de dissipation thermique peu couteux permettant une dissipation thermique élevée et une réduction du poids de l'ensemble de dissipation thermique et/ou d'un appareil électronique le contenant.

Pour cela, un premier aspect de la description concerne un ensemble de dissipation thermique comprenant :
- une plaque de base comprenant au moins une ouverture ainsi qu'au moins un élément de fixation pour maintenir un composant électronique en regard de l'au moins une ouverture,
- un dissipateur thermique indépendant de la plaque de base et comprenant au moins un contacteur thermique introduit au travers de l'au moins une ouverture et agencé pour être en contact thermique avec le composant électronique.

Dans une configuration assemblée, le dissipateur thermique est essentiellement localisé sur une première face de la plaque de base alors que le composant électronique et le contacteur thermique sont localisés sur une deuxième face de la plaque de base opposée à la première face. Préférentiellement, le contacteur thermique fait saillie de la plaque de base.

Un tel ensemble de dissipation thermique en deux parties peut être à la fois léger, peu couteux à fabriquer et à intégrer et obtenir une bonne performance thermique. La plaque de base peut avoir une fonction structurelle de support et/ou une fonction thermique de dissipation d'énergie thermique alors que le dissipateur thermique peut être limité à la dissipation thermique. Par exemple, un premier procédé de fabrication peut être utilisé pour la plaque de base et un deuxième procédé de fabrication peut être utilisé pour le dissipateur thermique. Ainsi, la plaque de base peut être une tôle emboutie et le dissipateur thermique peut être extrudé ou moulé.

Le dissipateur thermique est fourni d'un seul bloc de manière à réduire les coûts et optimiser la performance thermique. En outre, le dissipateur thermique comprend un relief opposé au contacteur thermique, le relief maximisant un échange thermique avec l'atmosphère environnante. Ce relief peut comprendre des plots, des lamelles, des ailettes ou encore des canaux ou des tranchées.

Le contacteur thermique comprend une surface de contact agencée pour être en contact thermique avec le composant électronique et une plaque de dissipation de laquelle le relief fait saillie. La surface de contact est fixée sur la plaque de dissipation de manière à permettre un passage de l'atmosphère environnante entre la plaque de dissipation et la surface de contact. En combinaison au relief en saillie, la plaque de base peut être confondue avec le relief et peut comprendre, par exemple, des angles ou des ondulations permettant la maximisation d'un échange thermique.

Avantageusement, le contacteur thermique comprend une surface de blindage agencée en retrait et autour de la surface de contact de façon à recevoir une couche de blindage électromagnétique pour le composant électronique. Préférentiellement, cette couche de blindage électromagnétique est configurée pour entourer le composant électronique quand le composant électronique est en contact thermique avec la surface de contact et peut être percé de façon à laisser un espace libre en son centre pour la surface de contact.

Avantageusement, les éléments de fixation sont agencés pour fixer le composant électronique de 3 mm à 30 mm de la plaque de base. Un tel écart avec le composant électronique peut permettre une dissipation thermique optimisée. Par exemple, le composant électronique est fixé directement ou au travers d'un circuit imprimé ou d'une carte électronique le supportant.

Un autre aspect de la présente description concerne un dispositif électronique comprenant :
- l'ensemble de dissipation thermique comme décrit précédemment,
- un composant électronique, fixé à la plaque de base de façon à être en contact thermique avec le contacteur thermique.

Un autre aspect de la présente description concerne un procédé de fabrication d'un ensemble de dissipation thermique comme décrit précédemment, comprenant :
- la fourniture de la plaque de base,
- la fourniture du dissipateur thermique,
- l'assemblage du dissipateur thermique sur la plaque de base, de façon à introduire le contacteur thermique du dissipateur thermique au travers de l'au moins une ouverture de la plaque de base.
Ce procédé peut permettre la fabrication simple et peu couteuse d'un dissipateur thermique facile à intégrer et performant thermiquement.

Avantageusement, le procédé comprend la fabrication de la plaque de base par emboutissage, ce qui permet de limiter le cout et le poids de la plaque de base. Des étapes de découpe et perforation peuvent aussi être prévues.

Avantageusement, le procédé comprend la fabrication du dissipateur thermique par extrusion, ce qui permet d'obtenir un haut niveau de performance thermique. Alternativement, la fabrication du dissipateur thermique est faite par moulage ou par usinage ou bien une combinaison de ces procédés.

### Description des figures

D'autres caractéristiques et avantages de la présente description apparaîtront plus clairement à la lecture de la description détaillée qui suit de mode(s) de réalisation donné(s) à titre d'exemple(s) nullement limitatif(s) et illustré(s) par les dessins annexés, dans lesquels :
La figure 1 représente une vue éclatée d'un ensemble de dissipation thermique selon la présente description avec deux composants électroniques ;
La figure 2 représente une vue d'une plaque de base selon la présente description ;
La figure 3 représente une vue opposée d'une plaque de base selon la figure 2 ;
La figure 4 représente une vue de profil d'un dissipateur thermique selon la présente description ;
La figure 5 représente une vue de trois quarts d'un dissipateur thermique selon la figure 4 ;
La figure 6 représente un ensemble de dissipation thermique selon la présente description en configuration assemblée ;La figure 7représente une vue opposée de l'ensemble de dissipation thermique selon la figure 6 ;
La figure 8 représente un ensemble de dissipation thermique de la figure 6 prêt au montage sur un circuit imprimé.

Un dissipateur thermique est un composant essentiel utilisé dans les domaines de l'électronique pour contrôler efficacement la chaleur générée par divers appareils électriques. Ce dispositif joue le rôle crucial d'équilibrer et de disperser la chaleur produite lors du fonctionnement des composants, comme les semi-conducteurs ou les microprocesseurs. La dissipation thermique est fondamentalement importante, car elle permet de maintenir une température critique à laquelle les appareils opèrent optimalement sans risque de défaillance.

Les dissipateurs thermiques sont conçus avec divers matériaux qui conduisent la chaleur, tels que le cuivre et l'aluminium, connus pour leur excellente conductivité thermique. Ils peuvent être fabriqués sous forme de plaques amovibles ou intégrées directement dans les designs des circuits électroniques. Le but est de transférer la chaleur vers un point d'évacuation extérieur, tel qu'une surface froide et ventilée ou une source de refroidissement externe telle que l'air frais.

L'utilité d'un dissipateur thermique dans les appareils électroniques réside principalement dans la maintenance d'un fonctionnement approprié, la prolongation de leur durée de vie, l'amélioration des performances et la garantie de sécurité. La chaleur excessive peut affecter négativement le fonctionnement des composants, entraînant une baisse du rendement ou même provoquer leur défaillance. En contrôlant efficacement la température interne, les dissipateurs thermiques aident à prévenir ces problèmes et assurent ainsi un bon fonctionnement à long terme des appareils électroniques.

Des dissipateurs thermiques ont pu être obtenus par extrusion : ce processus de fabrication permet de générer des profilés à l'aide d'une filière et apporte des solutions pour réduire le poids des dissipateurs. L'aluminium utilisé dans cette méthode de fabrication est plus performant thermiquement que celui de l'injection. De plus, ce procédé permet d'obtenir des épaisseurs plus fines et donc de réduire considérablement le volume et le poids de la pièce. L'inconvénient de l'extrusion est l'obligation de faire des formes simples. En effet, il ne permet pas de faire de formes complexes pour servir de structure pour notamment fixer mécaniquement les cartes électroniques et servir à l'assemblage à des pièces mécaniques.

Des dissipateurs thermiques ont pu être obtenus par moulage, par exemple en injectant de la matière conductrice thermiquement comme l'aluminium ou un de ses alliages dans un moule. Ce processus de fabrication permet de fabriquer des pièces complexes, mais il impose des épaisseurs plus conséquentes, par exemple des épaisseurs minimums de 2 mm et des angles de dépouilles d'au moins 3°. De plus, l'alliage d'aluminium utilisé pour l'injection est moins performant thermiquement en comparaison de l'extrusion. Des pièces lourdes et chères sont ainsi obtenues formant un dissipateur moins performant thermiquement avec un surplus de matière afin de respecter les épaisseurs minimums. En revanche, il est possible de réaliser une structure mécanique pour être fixée sur la carte ou des pièces mécaniques.

Enfin, une plaque emboutie peut faire office de dissipateur thermique : l'emboutissage est un processus de fabrication simple et peu onéreux permettant de réaliser des pièces de structure assez complexe pour permettre l'assemblage des cartes électroniques et des pièces mécaniques. Cependant, elle ne permet pas la réalisation d'ailettes en nombre pour avoir une grande surface d'échange thermique avec l'air ambiant et de ce fait avoir bonne performance thermique. Ainsi, dans le cas des plaques embouties faisant office de dissipateur, leur performance thermique reste assez faible.

Un ensemble de dissipation thermique selon la présente description a été conçu en vue de ces considérations et inclut une plaque de base et un dissipateur thermique indépendant de la plaque de base et emboitable ou agençable dans la plaque de base. Le dissipateur thermique est conçu pour être en contact thermique avec un composant électronique.

### Description des modes de réalisation

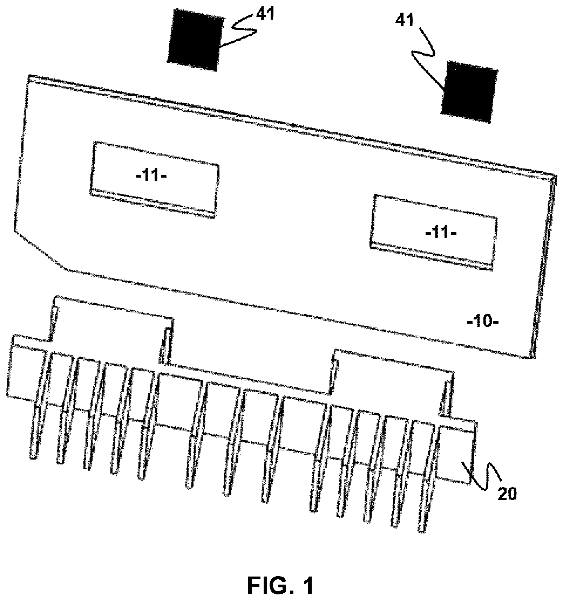

La figure 1 représente un ensemble de dissipation thermique comprenant une plaque de base 10 comprenant au moins une, par exemple deux ouvertures 11, et un dissipateur thermique 20 configuré pour s'emboiter dans la plaque de base 10, de manière à contacter au moins un, par exemple deux composants électroniques 41 situés sur une face opposée par rapport au dissipateur thermique 20.

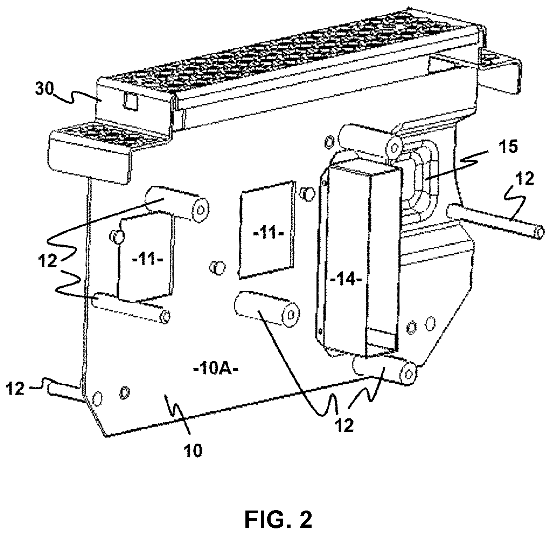

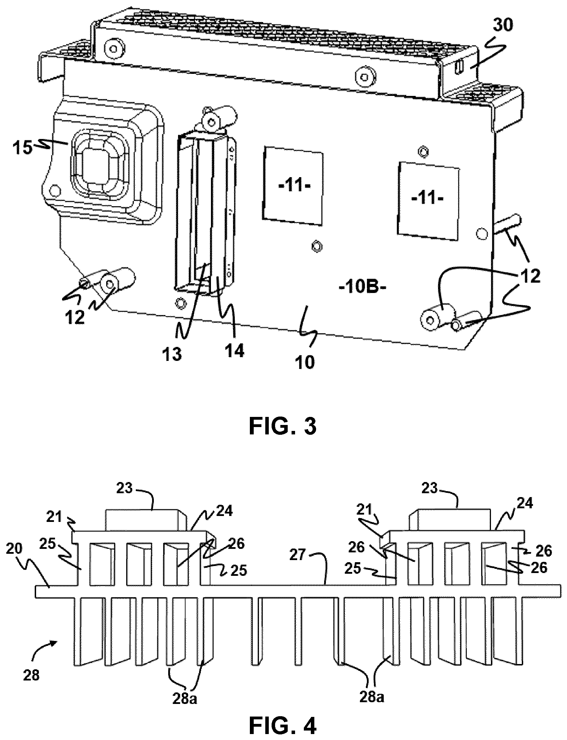

Les figures 2 et 3 montrent les deux faces de la plaque de base 10 comprenant au moins une ouverture 11 traversant la plaque de base 10, par exemple au moins deux ouvertures 11. Les ouvertures 11 sont par exemple carrées, mais peuvent avoir n'importe quelle géométrie et sont adaptées pour accueillir ou emboiter au moins une partie du dissipateur thermique 20. Par exemple, la plaque de base 10 peut comprendre une première face 10A et une deuxième face 10B opposée à la première face 10A.

La plaque de base 10 comprend au moins un élément de fixation 12, par exemple une pluralité d'éléments de fixation 12. Ces éléments de fixation peuvent être des plots agencés pour recevoir une vis ou un rivet ou bien pour être emboités avec un autre élément de fixation d'un autre élément à fixer à la plaque de base. Alternativement, les éléments de fixation 12 peuvent prendre d'autres formes comme des trous traversants ou des empreintes permettant un emboitement.

La plaque de base 10 peut comprendre au moins une autre ouverture permettant le passage d'un connecteur électrique ou d'une carte électronique, par exemple une ouverture de communication 13. Une telle ouverture de communication 13 peut être munie d'un élément de blindage électromagnétique 14 au besoin, par exemple supporté sur la plaque de base 10. Dans l'exemple des figures 2 et 3, cet élément de blindage électromagnétique 14 comprend deux sous éléments de blindage électromagnétique placé chacun sur une des première et deuxième faces 10A, 10B.

De plus, au moins une empreinte 15 peut être prévue pour loger un élément volumineux prévu en regard de la plaque de base 10. Cette empreinte 15 peut être un relief de la plaque de base 10, c'est-à-dire une portion déformée définissant un renfoncement et dégageant un volume permettant d'accueillir l'élément volumineux et/ou de se rapprocher d'un autre élément situé en regard de la face opposée de la plaque de base 10. En outre, une surface de l'empreinte 15 peut être en contact thermique avec l'élément volumineux ou l'autre élément si une dissipation thermique modérée est nécessaire. Ainsi, la plaque de base 10 peut être adaptée à différentes configurations internes d'un dispositif électronique et/ou peut permettre une dissipation thermique directe pour des composants électroniques générant peu de chaleur.

Enfin, d'autres éléments peuvent être supportés par la plaque de base 10, comme une grille d'aération 30 pour laisser l'air chaud s'échapper du dispositif électronique, afin de permettre ou d'optimiser le flux d'air sur au moins une des faces, par exemple sur les deux faces de la plaque de base 10. La grille d'aération 30 peut avoir un perçage irrégulier ou anisotrope de façon à forcer le flux d'air dans une certaine direction et/ou être munie d'un manchon ou de parois pour orienter le flux d'air. La grille d'aération 30 peut permettre également d'assurer un blindage électromagnétique pour répondre à des exigences de comptabilité électromagnétique (CEM).

La plaque de base 10 a donc un rôle de support ou de châssis, permettant de fixer et d'organiser des éléments et/ou des composants électroniques de part et d'autre de la plaque de base 10. De plus, la plaque de base 10 est préférentiellement fabriquée en un matériau conducteur thermique comme du métal, et peut donc contribuer à une fonction de dissipation thermique avec ou sans dissipateur thermique. Par exemple, la plaque de base 10 est une tôle emboutie, par exemple une tôle en acier préférentiellement inoxydable, une tôle en alliage d'aluminium, préférentiellement les séries 1xxx, 3xxx, 5xxxx comme connus de la personne du métier ou encore une tôle en cuivre ou en laiton.

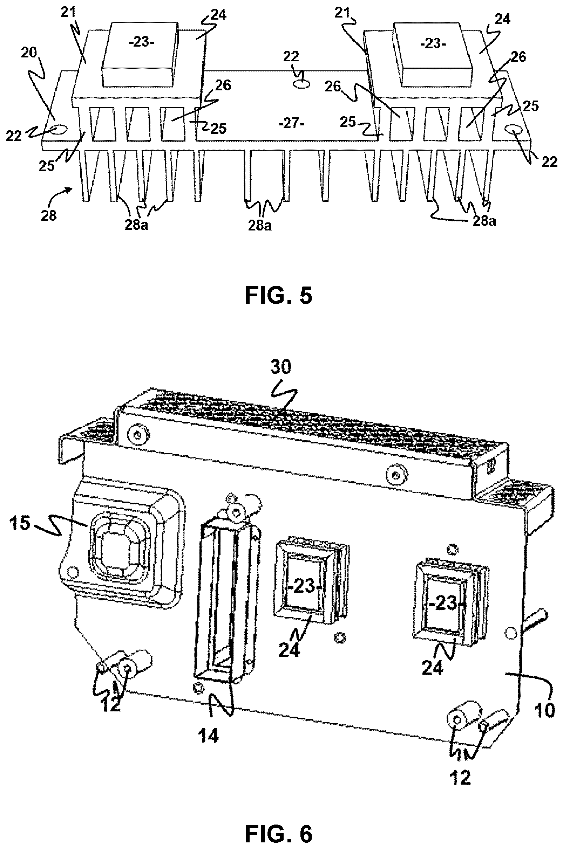

Les figures 4 et 5 montrent deux vues du dissipateur thermique 20. Le dissipateur thermique comprend au moins un contacteur thermique 21 agencé pour être en contact thermique avec un composant électronique, par exemple deux contacteurs thermiques 21 comme visibles sur les figures 4 et 5. De plus, le dissipateur thermique 20 peut comprendre au moins un ancrage 22 agencé pour permettre une fixation sur la plaque de base 10, par exemple au travers d'un élément de fixation 12 de la plaque de base 10 ou d'un autre élément de fixation comme un rivet ou une vis. Sur la figure 5, trois ancrages 22 sont visibles sous la forme de trous traversants.

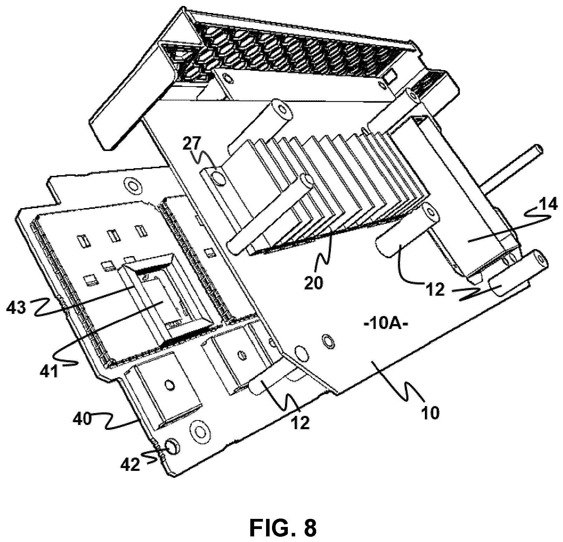

Préférentiellement, l'au moins un contacteur thermique 21 comprend une surface de contact 23 faisant saillie, c'est-à-dire placée au-dessus d'une surface de blindage 24. La surface de contact est agencée pour être en contact thermique avec un composant électronique et la surface de blindage 24 optionnelle est agencée pour recevoir une couche de blindage électromagnétique 43 telle qu'illustrée sur la figure 8. Alternativement, la surface supérieure du contacteur thermique 21 est prévue pour être en contact thermique avec le composant électronique 41. Dans ce cas, un blindage électromagnétique peut être prévu autour du contacteur thermique 21 si nécessaire.

Le contacteur thermique 21 peut faire saillie d'une plaque de dissipation 27, et peut être fixée à cette plaque de dissipation 27 de façon à permettre un échange thermique avec un milieu environnant. Dans les figures 4 et 5, une telle fixation est réalisée par des lamelles 25 définissant au moins un canal 26 ou tunnel entre la plaque de dissipation 27 et le contacteur thermique 21, le canal permettant à un flux d'air ou de gaz de circuler, par exemple l'air ambiant. Trois canaux 26 sont visibles sous chaque contacteur thermique 21 des figures 4 et 5.

Sur la plaque de dissipation 27, un relief 28 permet d'optimiser un échange thermique avec un milieu environnant. Le relief 28 fait saillie de la face de la plaque de dissipation 27 opposée à la face accueillant le contacteur thermique 21. Le relief 28 peut comprendre une pluralité de lamelles 28a ou d'ailettes, ou toute autre structure connue de l'homme du métier permettant la maximisation d'un échange thermique solide/gaz, comme des structures ondulations, des canaux ou des plots. Alternativement ou en combinaison, la plaque de dissipation 27 a une forme permettant d'optimiser l'échange thermique, par exemple une forme non planaire avec des ondulations ou des angles.

Le dissipateur thermique 20 est fabriqué d'un seul bloc dans un matériau conducteur thermique comme un métal, par exemple de l'aluminium ou un alliage avec de l'aluminium comme les alliages 6063 et 1050. Par exemple, le dissipateur thermique 20 est fabriqué par extrusion. Alternativement, le dissipateur thermique 20 est fabriqué par injection-moulage, par usinage ou par une combinaison de ces techniques. D'autres matériaux adaptés pour le dissipateur thermique 20 incluent le cuivre, le graphite, les matrices de métal (MMC) ou encore les céramiques techniques, par exemple à base de nitrure d'aluminium (AIN) ou de nitrure de bore (BN).

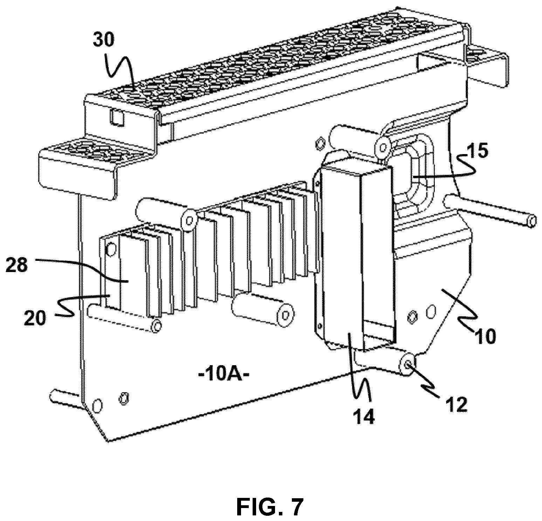

Les figures 6 et 7 montrent un ensemble de dissipation thermique selon la présente description en configuration assemblée. La plaque de dissipation 27 est ainsi fixée sur une face de la plaque de base 10 comme la première face 10 A, par exemple par des vis ou rivets (voir figure 7). Les contacteurs thermiques 21 sont passés au travers des ouvertures 11 correspondantes de la plaque de base 10, de manière à faire saillie de la plaque de base 10 sur la deuxième face 10B, opposée à la première face 10A sur laquelle la plaque de dissipation 27 du dissipateur thermique 20 est fixée. Préférentiellement, la plaque de dissipation 27 du dissipateur thermique 20 peut être fixée en contact thermique avec la plaque de base 10, par exemple en contact direct. De plus, le contacteur thermique 21 peut être en contact thermique avec la plaque de base 10, par exemple par un contact thermique direct avec au moins une des lamelles 25.

Un procédé de fabrication d'un ensemble de dissipation thermique peut comprendre les étapes suivantes. La plaque de base peut être fabriquée, par exemple par emboutissage d'une tôle, de façon à créer l'au moins une ouverture 11 et optionnellement les orifices nécessaires par exemple aux éléments de fixation 12 ainsi que l'au moins une ouverture de communication 13 optionnelle et l'au moins une empreinte 15 optionnelle selon l'application spécifique de l'ensemble de dissipation thermique. De plus, la plaque de base 10 peut être découpée aux bonnes dimensions. Des moyens de fixations 12, une grille d'aération 30 et/ou au moins un élément de blindage électromagnétique 14 peuvent alors être fixés à la plaque de base 10, selon le besoin, ou bien après l'étape d'assemblage décrite ci-dessous.

Dans le même temps ou bien avant ou après l'étape ci-dessus, le dissipateur thermique 20 peut être obtenu, par exemple par injection moulage, usinage ou préférentiellement par extrusion. Le dissipateur thermique 20 est ensuite assemblé à la plaque de base 10 pour obtenir l'ensemble de dissipation thermique, en introduisant le contacteur thermique 21 au travers de l'ouverture 11. Une étape de fixation peut être prévue pour fixer le dissipateur thermique 20 à la plaque de base 10, par exemple par vissage, rivetage ou verrouillage.

Une fois le dissipateur thermique 20 fixé à la plaque de base 10, l'ensemble de fixation thermique peut être fixé à un composant électronique, soit directement en fixant le composant électronique à la plaque de base 10 grâce aux éléments de fixation 12, soit indirectement en fixant une carte électronique 40 (PCB) supportant le composant électronique 41 à la plaque de base 10 grâce aux éléments de fixation 12, comme représenté sur la figure 8. Par exemple, des vis ou de rivets peuvent être introduits au travers d'orifices de fixation 42 de la carte électronique et se fixer dans les éléments de fixation 12, ou bien les orifices de fixation 42 peuvent emboiter une extrémité des éléments de fixation 12.

Le contacteur thermique 21 est alors mis en contact thermique avec le composant électronique 41 soit par contact direct ou au travers d'un gel thermique ou d'une couche de matière thermo conductrice, comme un pad en silicone. De plus, une couche de blindage électromagnétique 43 peut être pourvue autour du composant électronique 41 et venir en contact ou être écrasée par la surface de blindage 24 de manière à fournir une bonne étanchéité électromagnétique sans gêner le transfert thermique.

Le composant électronique 41 et/ou la carte électronique 40 peut ainsi être fixé de manière espacée de la plaque de base 10, par exemple grâce aux éléments de fixation 12. Par exemple, un espace de 3 à 30 mm, préférentiellement 6 à 24 mm et encore préférentiellement 11 à 19 mm est prévu entre le composant électronique 41 et/ou la carte électronique 40 et la plaque de base. Cet espacement correspond ainsi à une hauteur du dissipateur thermique 20 en saillie de la plaque de base 10, par exemple la hauteur du contacteur thermique 21 et des lamelles 25 moins l'épaisseur de la plaque de base 10. Alternativement ou en combinaison, cet espacement correspond à une hauteur des éléments de fixation 12, par exemple mesurée à partir de la plaque de base 10.

Dans un exemple non représenté, un deuxième composant électronique ou une deuxième carte électronique peut être fixée sur la première face 10A opposée à la carte électronique 40. Par exemple, cette deuxième carte électronique peut inclure des composants électroniques dissipant moins de chaleur que la carte électronique 40, auquel cas un dissipateur thermique n'est pas nécessaire. La dissipation thermique peut alors de faire naturellement ou bien par un simple contact thermique avec la plaque de base 10.

Dans le cas contraire, un deuxième dissipateur thermique peut être fixé sur la plaque de base 10, au travers d'autres ouvertures de la plaque de base (non représentées) et de manière inversée par rapport au dissipateur thermique 20. De cette façon, au moins deux cartes électroniques peuvent être montées de part et d'autre de la plaque de base. De plus, une communication électrique ou électronique entre ces au moins deux cartes électroniques peut être assurée par un connecteur, un câble ou une carte électronique de communication introduit au travers de l'ouverture de communication 13, et par exemple entouré de l'élément de blindage électromagnétique 14.

L'empreinte 15 peut permettre le logement d'un composant électronique ou de tout autre élément encombrant sur une face de la plaque de base et/ou d'assurer une dissipation thermique modérée pour cet élément électronique, au travers d'un contact thermique entre une surface de l'empreinte 15 et ce composant électronique. De plus, la plaque de base 10 peut être elle-même fixée à un boitier ou un châssis et/ou fixer des éléments accessoires comme du câblage, un ou plusieurs ventilateurs et/ou des éléments d'un système de refroidissement liquide (non représentée).

La plaque de base 10 a donc une fonction structurelle en supportant et fixant le dissipateur thermique 20 et la carte électronique 40 et/ou le composant électronique 41. Elle permet ainsi d'alléger un dispositif électronique et de simplifier sa fabrication en minimisant le nombre d'éléments nécessaires à la fixation des composants électroniques et à l'évacuation de la chaleur générée, pour un cout réduit. Le dissipateur thermique peut être optimisé pour la dissipation thermique, sans tenir compte de contraintes mécaniques. Il peut être fabriqué par un procédé différent de celui de la plaque de base, par exemple par extrusion, et ainsi permettre un échange de chaleur optimal.

En fonctionnement, le composant électronique 41 va générer de la chaleur et cette chaleur va être transmise au dissipateur thermique 20, permettant un échange de chaleur optimal avec le milieu environnant au travers du relief 28 et préférentiellement de la plaque de dissipation 27, des lamelles 25 et de l'au moins un canal 26.

En outre, la plaque de base 10 est préférentiellement fabriquée dans un matériau conducteur thermique et est préférentiellement en contact thermique avec le dissipateur thermique 20, accroissant par là même la surface d'échange et optimisant ainsi le transfert de l'énergie thermique généré par le composant électronique au milieu extérieur.

### Application industrielle

Un ensemble de dissipation thermique selon la présente description, et sa fabrication, sont susceptibles d'application industrielle afin de structurer et d'assurer l'échange thermique dans tout type d'appareil électronique ayant tout type de composant électronique.

Une liste non exhaustive d'appareils électroniques dans lesquels un ou des modes de réalisation sont susceptibles d'être mis en œuvre comprend les ordinateurs, les cartes graphiques, les serveurs informatiques, les routeurs, les passerelles d'accès à internet ou à un réseau étendu, les switches réseaux, les téléviseurs, les écrans informatiques, les set-top box, les amplificateurs audio de puissance, les variateurs de lumière pour l'éclairage à LED de haute puissance, les alimentations électriques pour ordinateurs et autres appareils électroniques, les chargeurs rapides pour smartphones et tablettes, les onduleurs pour les systèmes d'alimentation sans interruption, les contrôleurs de moteurs électriques pour les véhicules électriques et les équipements industriels, les transformateurs électriques de haute puissance, les amplificateurs RF pour les équipements de communication sans fil, les régulateurs de tension pour les systèmes électroniques de puissance, les véhicules électriques, les systèmes d'énergie renouvelables et les systèmes de stockage d'énergie par batterie.

Une liste non exhaustive de composants électroniques comprend les processeurs de traitement généraliste (CPU) et/ou de traitement dédié (DSP, FGPA, etc.) pour ordinateurs de bureau, portables, serveurs, switch et routeurs, les processeurs graphiques (GPU) pour ordinateurs de bureau, portables et serveurs, passerelles, équipements multimédia, les modules de mémoire (RAM) pour ordinateurs de bureau, switches, routeurs, portables et serveurs, les transistors de puissance (MOSFET, IGBT, BJT), les diodes de puissance (diodes Schottky, diodes PIN), les régulateurs de tension linéaires (LDO, régulateurs à faible chute de tension), les régulateurs de tension à découpage (Buck, Boost, Buck-Boost), les amplificateurs opérationnels de puissance, les thyristors (SCR, TRIAC), les redresseurs contrôlés au silicium (SCR), les modules IGBT pour les variateurs de fréquence et les onduleurs, les résistances de puissance (résistances bobinées, résistances à film épais), les inductances de puissance (inductances à noyau de fer, inductances à noyau de ferrite), les transformateurs de puissance (transformateurs haute fréquence, transformateurs basse fréquence), les modules de LED de puissance pour l'éclairage, les moteurs électriques, les modules de puissance pour les équipements de télécommunication (amplificateurs RF, émetteurs-récepteurs), les modules de puissance pour les équipements médicaux (amplificateurs à ultrasons, générateurs de rayons X) et les modules de puissance pour les équipements de soudage (onduleurs de soudage, redresseurs de soudage).

En particulier, on peut noter que la plaque de base n'est pas limitée à une forme ou des dimensions spécifiques, mais peut être adaptée selon l'application désirée. Le dissipateur thermique peut avoir toute forme appropriée et en particulier tout type de relief. Le contacteur thermique peut avoir toute forme appropriée et n'est pas limité à un parallélépipède. Plusieurs plaques de base peuvent être fixées ensemble et chaque plaque de base peut comprendre un ou plusieurs dissipateurs thermiques, fixés de manière parallèle ou en quinconce sur un côté ou sur les deux côtés de la plaque de base.

## Revendications

1. Ensemble de dissipation thermique comprenant :
a. une plaque de base (10) comprenant au moins une ouverture (11) ainsi qu'au moins un élément de fixation (12) pour maintenir un composant électronique (41) en regard de l'au moins une ouverture (11), et
b. un dissipateur thermique (20) indépendant de la plaque de base (10) et comprenant au moins un contacteur thermique (21) introduit au travers de l'au moins une ouverture (11) et agencé pour être en contact thermique avec le composant électronique (41) ; et
dans lequel le dissipateur thermique (20) est fourni d'un seul bloc et comprend au moins un relief (28) opposé au contacteur thermique (21), le relief (28) étant configuré pour maximiser un échange thermique avec l'atmosphère environnante ; le contacteur thermique (21) comprenant une surface de contact (23) agencée pour être en contact thermique avec le composant électronique (41) et une plaque de dissipation (27) de laquelle le relief (28) fait saillie, la surface de contact (23) étant fixée sur la plaque de dissipation (27) de manière à permettre un passage de l'atmosphère environnante entre la plaque de dissipation (27) et la surface de contact (23).

2. Ensemble de dissipation thermique selon la revendication 1, dans lequel le contacteur thermique (21) comprend une surface de blindage (24) agencée en retrait et autour de la surface de contact (23) de façon à recevoir une couche de blindage électromagnétique (43) pour le composant électronique (41).

3. Ensemble de dissipation thermique selon l'une des revendications 1 ou 2, dans lequel les éléments de fixation (12) sont agencés pour fixer le composant électronique (41) de 3 mm à 30 mm de la plaque de base (10).

4. Dispositif électronique comprenant :
- l'ensemble de dissipation thermique selon l'une des revendications 1 à 3; et
- un composant électronique (41), fixé à la plaque de base (10) de façon à être en contact thermique avec le contacteur thermique (20).

5. Procédé de fabrication d'un ensemble de dissipation thermique selon l'une des revendications 1 à 3, comprenant :
- la fourniture de la plaque de base (10),
- la fourniture du dissipateur thermique (20),
- l'assemblage du dissipateur thermique (20) sur la plaque de base, de façon à introduire le contacteur thermique (21) du dissipateur thermique (20) au travers de l'au moins une ouverture (11) de la plaque de base (10).

6. Procédé de fabrication selon la revendication 5, comprenant la fabrication de la plaque de base (10) par emboutissage.

7. Procédé de fabrication selon la revendication 6, comprenant la fabrication du dissipateur thermique (20) par extrusion.

8. Utilisation d'un ensemble de dissipation thermique selon l'une des revendications 1 à 3, pour dissiper l'énergie thermique d'un composant électronique (41).

## Patentansprüche

1. Wärmeableitungseinheit, umfassend:
a. eine Grundplatte (10), umfassend mindestens eine Öffnung (11) sowie mindestens ein Befestigungselement (12) zum Halten eines elektronischen Bauteils (41) gegenüber der mindestens einen Öffnung (11), und
b. einen Kühlkörper (20), der unabhängig von der Grundplatte (10) ist und umfassend mindestens einen Wärmekontaktgeber (21), der durch die mindestens eine Öffnung (11) eingeführt ist und angeordnet ist, um mit dem elektronischen Bauteil (41) in Wärmekontakt zu stehen; und
wobei der Kühlkörper (20) aus einem einzigen Block bereitgestellt ist und mindestens ein Relief (28) gegenüber dem Wärmekontaktgeber (21) umfasst, wobei das Relief (28) zum Maximieren eines Wärmeaustauschs mit der umgebenden Atmosphäre konfiguriert ist; der Wärmekontaktgeber (21) umfassend eine Kontaktoberfläche (23), die angeordnet ist, um in Wärmekontakt mit dem elektronischen Bauteil (41) zu stehen, und eine Ableitungsplatte (27), von welcher das Relief (28) vorsteht, wobei die Kontaktoberfläche (23) auf der Ableitungsplatte (27) befestigt ist, um einen Durchgang der umgebenden Atmosphäre zwischen der Ableitungsplatte (27) und der Kontaktoberfläche (23) zu ermöglichen.

2. Wärmeableitungseinheit nach Anspruch 1, wobei der Wärmekontaktgeber (21) eine Abschirmoberfläche (24) umfasst, die zurückversetzt und um die Kontaktoberfläche (23) herum angeordnet ist, um eine elektromagnetische Abschirmschicht (43) für das elektronische Bauteil (41) aufzunehmen.

3. Wärmeableitungseinheit nach einem der Ansprüche 1 oder 2, wobei die Befestigungselemente (12) zum Befestigen des elektronischen Bauteils (41) von 3 mm bis 30 mm von der Grundplatte (10) angeordnet sind.

4. Elektronische Vorrichtung, umfassend:
- die Wärmeableitungseinheit nach einem der Ansprüche 1 bis 3 und
- ein elektronisches Bauteil (41), das an der Grundplatte (10) befestigt ist, um in Wärmekontakt mit dem Wärmekontaktgeber (20) zu stehen.

5. Verfahren zum Fertigen einer Wärmeableitungseinheit nach einem der Ansprüche 1 bis 3, umfassend:
- das Bereitstellen der Grundplatte (10),
- das Bereitstellen des Kühlkörpers (20),
- das Montieren des Kühlkörpers (20) auf der Grundplatte, um den thermischen Kontaktgeber (21) des Kühlkörpers (20) durch die mindestens eine Öffnung (11) der Grundplatte (10) einzuführen.

6. Verfahren zum Fertigen nach Anspruch 5, umfassend das Fertigen der Grundplatte (10) durch Tiefziehen.

7. Verfahren zum Fertigen nach Anspruch 6, umfassend das Fertigen des Kühlkörpers (20) durch Extrusion.

8. Verwendung einer Wärmeableitungseinheit nach einem der Ansprüche 1 bis 3, zum Ableiten der Wärmeenergie eines elektronischen Bauteils (41).

## Claims

1. A heat dissipation assembly comprising:
a. a base plate (10) comprising at least one opening (11) and at least one attachment element (12) for holding an electronic component (41) facing the at least one opening (11), and
b. a heat sink (20) independent of the base plate (10) and comprising at least one thermal switch (21) inserted through the at least one opening (11) and arranged to be in thermal contact with the electronic component (41); and
wherein the heat sink (20) is provided in one piece and comprises at least one relief (28) opposite the thermal switch (21), the relief (28) being configured to maximize heat exchange with the surrounding atmosphere; the thermal switch (21) comprising a contact surface (23) arranged to be in thermal contact with the electronic component (41) and a dissipation plate (27) from which the relief (28) protrudes, the contact surface (23) being attached to the dissipation plate (27) so as to allow the surrounding atmosphere to pass between the dissipation plate (27) and the contact surface (23).

2. The heat dissipation assembly according to claim 1, wherein the thermal switch (21) comprises a shielding surface (24) arranged recessed and around the contact surface (23) so as to receive an electromagnetic shielding layer (43) for the electronic component (41).

3. The heat dissipation assembly according to either claim 1 or claim 2, wherein the attachment elements (12) are arranged to attach the electronic component (41) between 3 mm and 30 mm from the base plate (10).

4. An electronic device comprising:
- the heat dissipation assembly according to any of claims 1 to 3; and
- an electronic component (41), attached to the base plate (10) so as to be in thermal contact with the thermal switch (20).

5. A method for manufacturing a heat dissipation assembly according to any of claims 1 to 3 comprising:
- providing the base plate (10),
- providing the heat sink (20),
- assembling the heat sink (20) to the base plate, so as to insert the thermal switch (21) of the heat sink (20) through the at least one opening (11) in the base plate (10).

6. The manufacturing method according to claim 5, comprising manufacturing the base plate (10) by deep drawing.

7. The manufacturing method according to claim 6, comprising manufacturing the heat sink (20) by extrusion.

8. Use of a heat dissipation assembly according to any of claims 1 to 3, for dissipating thermal energy from an electronic component (41).
